# EUROPEAN PATENT APPLICATION

(11) **EP 4 199 061 A1**
(43) Date of publication of application: **21.06.2023**
(21) Application number: 22205532.9
(22) Date of filing: 04.11.2022
(51) Int. Cl.: H01L 21/822, H01L 21/8238, H01L 27/06, H01L 27/092, H01L 29/775, H01L 29/66

(54) **STACKED TRANSISTOR STRUCTURES WITH DIFFERENT GATE DIELECTRIC MATERIALS**

(30) Priority: 17.12.2021 US 202117554791
(71) Applicant: Intel Corporation, Santa Clara, CA 95054 (US)
(72) Inventor: Thomas, Nicole K., Portland, 97209 (US); Mattson, Eric, Portland, 97225 (US); Lee, Sudarat, Hillsboro, 97124 (US); Atanasov, Sarah, Beaverton, 97003 (US); Jezewski, Christopher, Portland, 97229 (US); Mokhtarzadeh, Charles, Portland, 97220 (US); Michaelos, Thoe, Portland, 97209 (US); Tung, I-Cheng, Hillsboro, 97124 (US); Kuo, Charles, Hillsboro, 97124 (US); Clendenning, Scott, Portland, 97225 (US); Metz, Matthew, Portland, 97229 (US)
(74) Representative: Goddar, Heinz J.

(57) **Abstract**

An integrated circuit includes a lower (130) and upper (150) device portions including bodies of semiconductor material (112) extending horizontally between first source and drain regions in a spaced-apart vertical stack. A first gate structure is around a body (112) in the lower device portion (130) and includes a first gate electrode (120a) and a first gate dielectric (114, 116a). A second gate structure is around a body (112) in the upper device portion (150) and includes a second gate electrode (120b) and a second gate dielectric (114, 116b), where the first gate dielectric is compositionally distinct from the second gate dielectric. In some embodiments, a dipole species has a first concentration in the first gate dielectric and a different second concentration in the second gate dielectric. A method of fabrication is also disclosed.

## Description

### BACKGROUND

The gate oxide of a metal oxide semiconductor field effect transistor (MOSFET) is a layer of dielectric material between the gate electrode and the source and drain terminals of the transistor. The gate oxide also separates the gate electrode from the conductive channel that connects the source and drain regions when the transistor is turned on. The gate oxide can be made of high-κ dielectric material. A gate conductor is deposited over the gate oxide to define the gate structure. The gate conductor can be made of, for example, highly doped silicon, or tungsten. The gate voltage required to turn on the transistor is referred to as the threshold voltage Vₜₕ and is defined in part by the work function of the gate electrode. There remain a number of non-trivial issues with respect to setting the threshold voltage Vₜₕ of a given transistor.

### BRIEF DESCRIPTION OF THE DRAWINGS

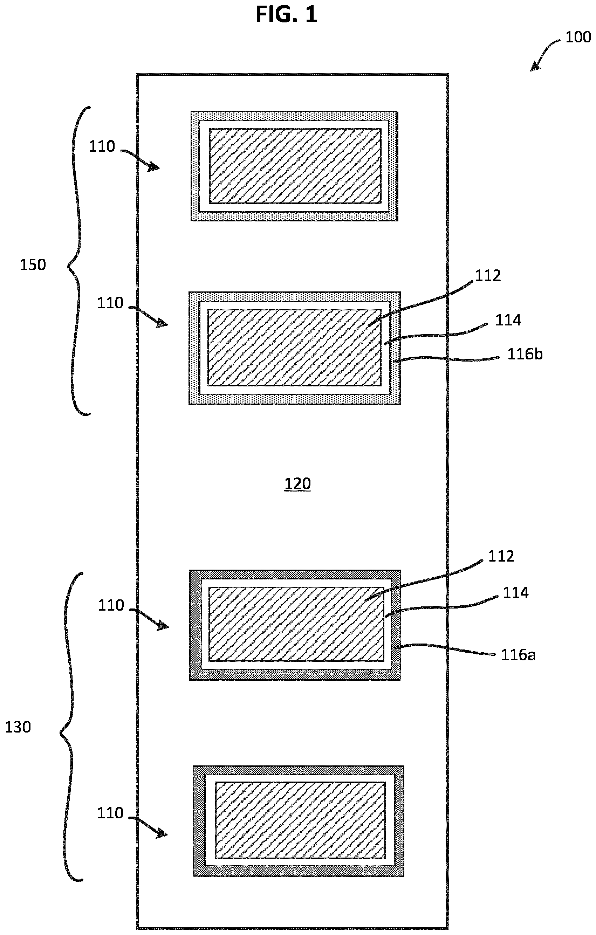

FIG. 1 illustrates a cross-sectional view taken through the gate structure of a stacked gate-all-around transistor structure with an upper device portion and a lower device portion, where one or more gate materials are compositionally different in the upper and lower device portions, in accordance with an embodiment of the present disclosure.

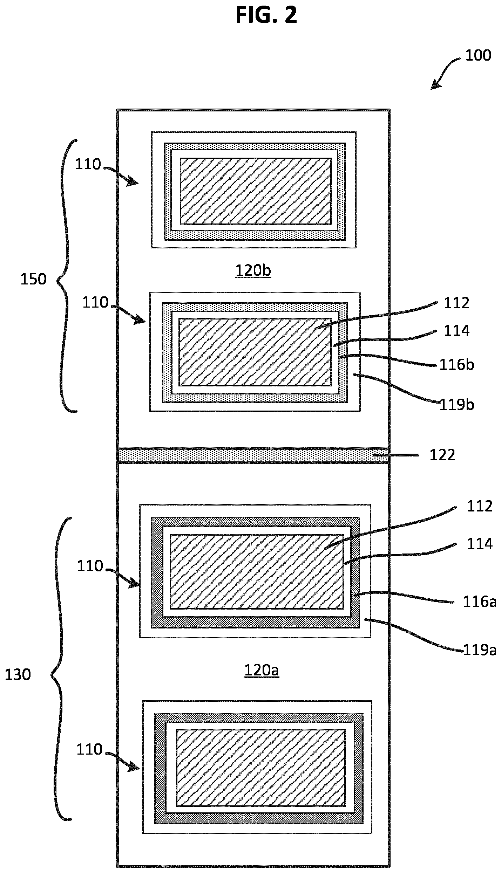

FIG. 2 illustrates a cross-sectional view taken through the gate structure of a stacked gate-all-around transistor structure with an upper device portion and a lower device portion, where the gate dielectric and the gate electrode are both compositionally different in the upper and lower device portions, in accordance with an embodiment of the present disclosure.

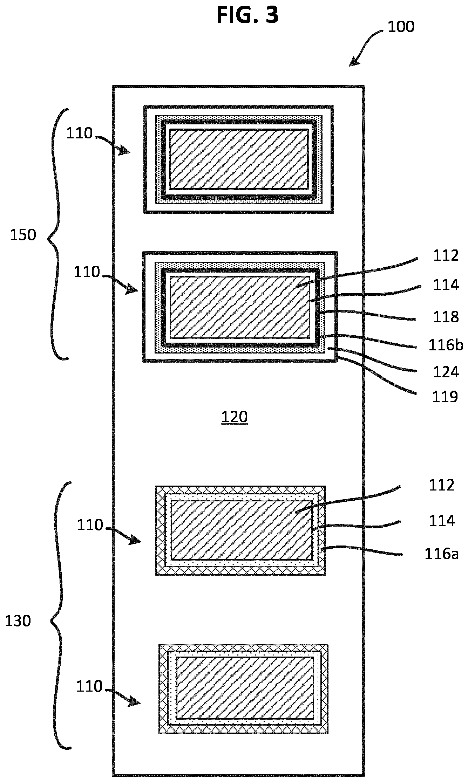

FIG. 3 illustrates a cross-sectional view taken through the gate structure of a stacked gate-all-around transistor structure with an upper device portion and a lower device portion, where the gate structure in the upper device portion includes a dipole species concentrated at the interface between an oxide native to the channel region and a high-κ gate dielectric, in accordance with an embodiment of the present disclosure.

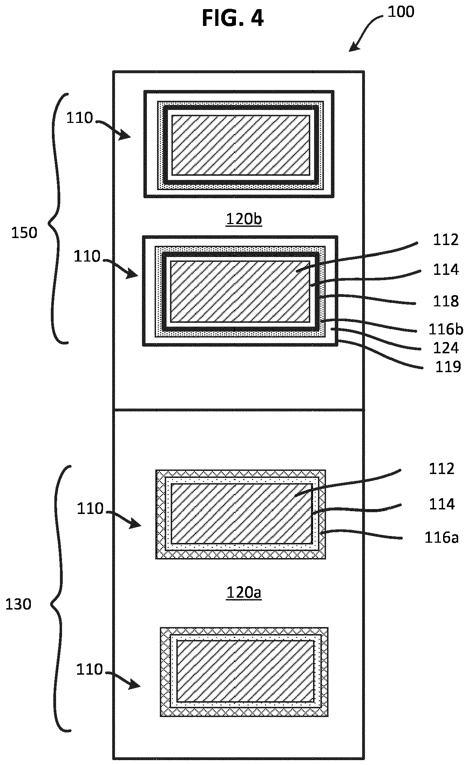

FIG. 4 illustrates a cross-sectional view taken through the gate structure of a stacked gate-all-around transistor structure with an upper device portion and a lower device portion, where the gate structure in the upper device portion includes one or more materials not found in the lower device portion, in accordance with an embodiment of the present disclosure.

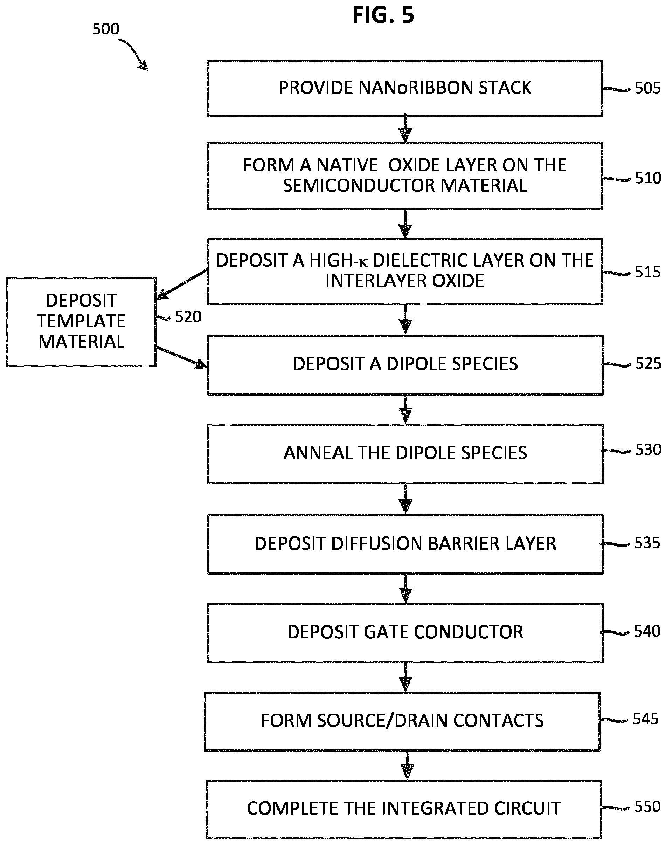

FIG. 5 illustrates a method of forming a gate structure of a stacked gate-all-around transistor device, in accordance with an embodiment of the present disclosure.

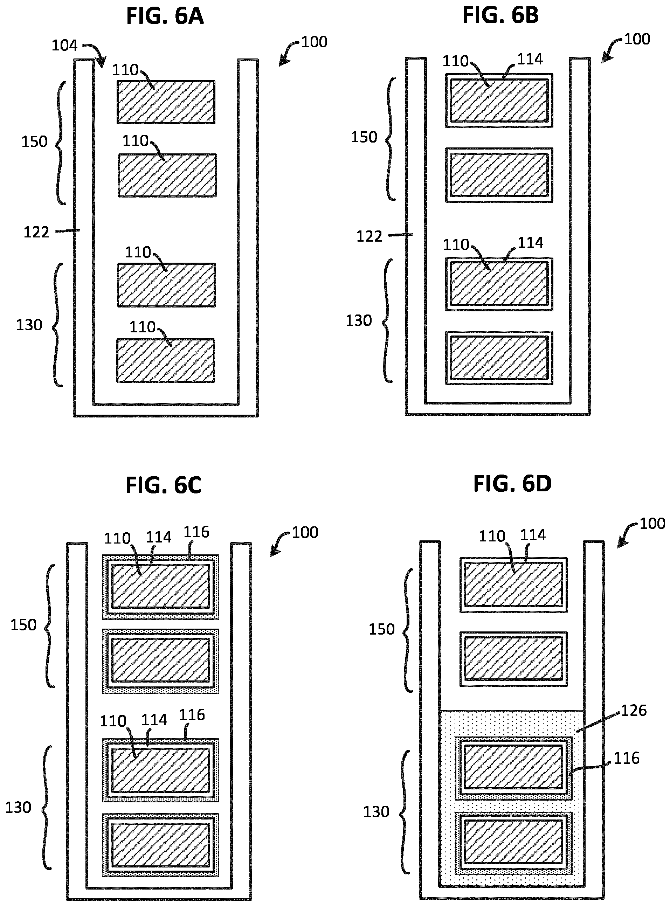

FIGS. 6A-6H illustrate cross-sectional views of the channel region of a gate-all-around transistor structure at various stages of gate processing, in accordance to some embodiments of the present disclosure.

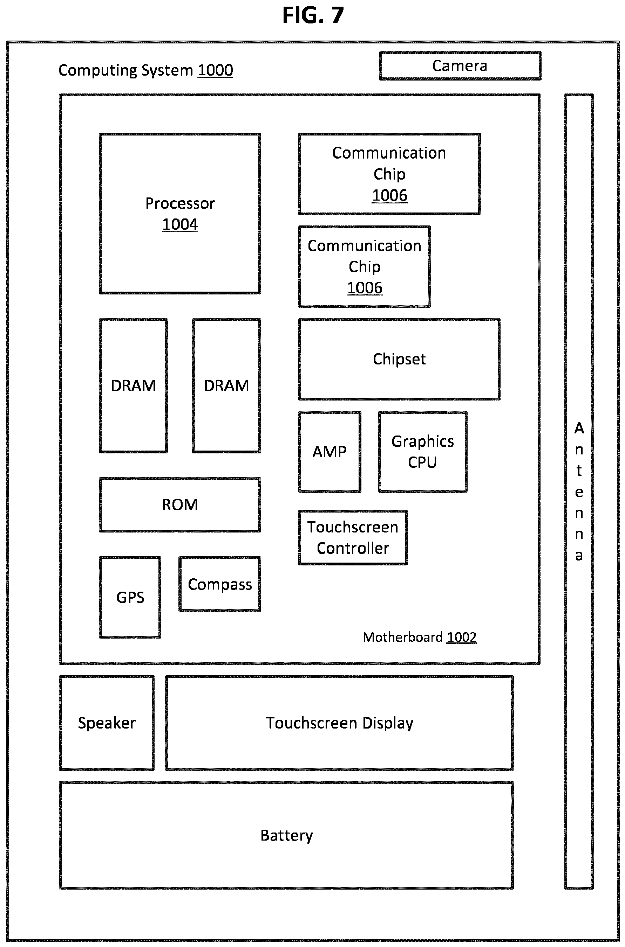

FIG. 7 illustrates an example computing system implemented with integrated circuit structures and/or transistor devices formed in accordance with some embodiments of the present disclosure.

The figures depict various embodiments of the present disclosure for purposes of illustration only. Numerous variations, configurations, and other embodiments will be apparent from the following detailed discussion. Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., tapered sidewalls and rounded corners), and some features may have surface topology or otherwise be non-smooth, given real-world limitations of the processing equipment and techniques used.

### DETAILED DESCRIPTION

Techniques are disclosed for fabricating stacked gate-all-around transistor structures in which individual semiconductor bodies (e.g., nanoribbons, nanosheets, nanowires) in a stack utilize different materials in the gate structure, such as the high-κ dielectric, field effect modulation species, gate conductor, and/or a diffusion barrier layer. In accordance with one embodiment, a stacked nanoribbon transistor structure includes a lower device portion with at least one nanoribbon and an upper device portion with at least one nanoribbon, the nanoribbons extending horizontally and arranged in a spaced-apart vertical stack. Nanoribbons in the lower device portion can have a first high-κ gate dielectric that is different from the high-κ gate dielectric in the upper device portion. As such, when the gate structure includes a dipole species, the metal of the dipole species may have a different diffusion rate through the first and second high-κ gate dielectrics and therefore can result in different concentrations of the dipole species at the interface between an oxide native to the nanoribbons (or other semiconductor body) and the high-κ dielectric. In some embodiments, different gate metals can be used in the upper and lower portions of the device. Further, some embodiments may include a diffusion barrier material (e.g., tantalum nitride) between the gate conductor and the gate dielectric.

In a method of gate processing, masking techniques can be employed to provide different dielectric materials in the upper and lower device portions. In some embodiments, a template layer of titanium nitride (TiN) or other suitable material can be selectively deposited on the high-κ dielectric of nanoribbons in one device portion of the nanoribbon stack. The dipole modulation species preferentially deposits on the template material. Annealing causes the dipole modulation species to diffuse through the high-κ dielectric and concentrate at the interface with an oxide native to the nanoribbons.

For a device including both NMOS and PMOS channel regions, for example, differences in the gate dielectric can be used with a dipole species to set the threshold voltage Vₜₕ. Methodologies according to the present disclosure are particularly well-suited to a stacked gate-all-around transistor where material layer thicknesses are limited by the narrow spacing between adjacent nanowires, nanoribbons or nanosheets. Numerous configurations will be apparent in light of the present disclosure.

### GENERAL OVERVIEW

Field effect transistors (FETs) have been scaled to smaller and smaller sizes to achieve faster circuit operation. Such scaling has resulted in the development of the nanowire, nanoribbon, and nanosheet transistors, sometimes more generally called gate-all-around (GAA) transistors. For example, the GAA channel region can have one or more nanowires (or nanoribbons or nanosheets) extending between the source and drain regions. To further increases device density, GAA transistors can be arranged in a vertical stack, such as a vertical stack of nanoribbons that extend horizontally between the source and drain regions. GAA transistors can be fabricated in a stacked configuration, such as when an NMOS transistor is positioned vertically above a PMOS transistor or vice versa. Such stacked nanoribbon transistor device configurations are useful for memory cells, logic cells, and CMOS applications, for example. In a stack of nanoribbons, nanosheets, or nanowires, however, the small spacing between the individual semiconductor bodies making up the stack can limit the layer thickness of the high-κ dielectric and other materials. This problem can be particularly acute when the semiconductor bodies have the pancake-like geometry of a nanoribbon or nanosheet. For example, nanoribbons can have a cross-sectional shape with a vertical thickness of about 5 nm, a horizontal dimension of 10-30 nm, and vertical spacing between nanoribbons of 5-20 nm. The small spacing between nanoribbons and sheets, and the associated limits on material thicknesses, can affect the ability to set the threshold voltage of the device.

The threshold voltage Vₜₕ of a transistor is the minimum voltage required to create a conductive path. For a given device, the threshold voltage can depend on the choice of gate dielectric and also depend on the thickness of that gate dielectric, which can include a native oxide on the surface of the channel material and a high-κ dielectric material on the native oxide, for example. The efficiency of setting Vₜₕ can similarly depend on the thickness of the work function metal in GAA devices. For the same reason, small vertical spacing between stacked semiconductor bodies (e.g., nanoribbons and nanosheets) limits the thickness of the work function metal, and therefore limits the ability to set the threshold voltage. Small spacing between the semiconductor bodies can also result in material thickness variations, which in turn result in variations in threshold voltage, Vₜₕ. Variations in threshold voltage may be particularly evident when the metal thickness is small as may be required for closely spaced semiconductor bodies.

To address this and other challenges, a stacked GAA transistor device can utilize gate oxides and/or dipole species to control setting the threshold voltage. Methodologies of the present disclosure enable efficient setting of the threshold voltage while having a near-zero thickness (e.g., a few angstroms (Å) or a monolayer) of the dipole species, in some embodiments. In some embodiments, different gate dielectrics are used in upper and lower portions of the semiconductor body stack, resulting in different diffusivity of the dipole species and therefore different final values of the threshold voltage. As will be appreciated in light of this description, the high-κ gate dielectric material can be selected based on its ability to control the amount of dipole species at the native oxide, and therefore the associated shift in threshold voltage, Vₜₕ. For example, a stacked GAA transistor structure can have first and second device portions that use the same dipole species, but different high-κ gate dielectrics in the device portions for PMOS and NMOS devices in the same nanoribbon stack. In some embodiments, controlling the location of the dipole species being deposited can induce voltage shifts in some nanoribbons but not others, such as by using a selective deposition process. For example, the dipole species can be selectively deposited on a template material (e.g., TiN) that is present on some, but not all, nanoribbons in the stack. Alternately, the thickness of the template material can be different in different portions of the nanoribbon stack in order to control diffusion of the dipole species to the native oxide.

In some embodiments, the techniques described herein can be used to benefit n-channel devices (e.g., NMOS) and/or p-channel devices (e.g., PMOS), such as a nanoribbon stack including both NMOS and PMOS nanowires. Further, in some embodiments, the techniques described herein can be used to form complementary transistor circuits (such as CMOS circuits), where the techniques can be used to benefit one or more of the included n-channel and p-channel transistors making up the CMOS circuit. Further yet, in some embodiments, although the techniques described herein are particularly applicable to gate-all-around (GAA) devices (e.g., nanowire, nanoribbon, or nanosheet), the techniques can similarly be used to benefit a multitude of transistor configurations, such as planar and non-planar configurations, where the non-planar configurations may include finned or FinFET configurations (e.g., dual-gate or tri-gate), forksheet transistors, or some combination thereof (e.g., beaded-fin configurations), to provide a few examples. The techniques described herein may be used to benefit logic and memory transistor devices or transistor-based devices used for other suitable applications (e.g., amplification, switching, etc.).

In addition to diversity of gate materials in the upper and lower device portions, transistors with compositionally different channel materials can be formed in different portions of the device, such as for CMOS applications. For instance, a nanoribbon stack can include nanoribbons having a first channel material in a first device portion to be used for one or more p-channel transistor devices (e.g., one or more PMOS devices), and nanoribbons of a second channel material in a second device portion above or below the first device portion, to be used for one or more n-channel transistor devices (e.g., one or more NMOS devices).

As will be further appreciated in light of this disclosure, reference to nanoribbons is also intended to include other gate-all-around channel regions, such as nanowires, nanosheets, and other such semiconductor bodies around which a gate structure can wrap. To this end, the use of a specific channel region configuration (e.g., nanoribbon) is not intended to limit the present description to that specific channel configuration. Rather, the techniques provided herein can benefit any number of channel configurations that include semiconductor bodies in which it is difficult to impart lateral strain, whether those bodies be nanowires, nanoribbons, nanosheets or some other body (such as those of a forksheet transistor device).

The use of "Group IV semiconductor material" (or "Group IV material" or generally, "IV") herein includes at least one Group IV element (e.g., silicon, germanium, carbon, tin), such as silicon (Si), germanium (Ge), silicon-germanium (SiGe), and so forth. The use of "Group III-V semiconductor material" (or "Group III-V material" or generally, "III-V") herein includes at least one Group III element (e.g., aluminum, gallium, indium) and at least one Group V element (e.g., nitrogen, phosphorus, arsenic, antimony, bismuth), such as gallium arsenide (GaAs), indium gallium arsenide (InGaAs), indium aluminum arsenide (InAlAs), gallium phosphide (GaP), gallium antimonide (GaSb), indium phosphide (InP), gallium nitride (GaN), and so forth. Note that Group III may also be known as the boron group or IUPAC Group 13, Group IV may also be known as the carbon group or IUPAC Group 14, and Group V may also be known as the nitrogen family or IUPAC Group 15.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. If two materials are elementally different or distinct, then one of the materials has an element that is not in the other material.

Note that the use of "source/drain" herein is simply intended to refer to a source region or a drain region or both a source region and a drain region. To this end, the forward slash ("/") is not intended to implicate any particular structural limitation or arrangement with respect to source and drain regions, or any other materials or features that are listed herein in conjunction with a forward slash.

Use of the techniques and structures provided herein may be detectable using tools such as electron microscopy including cross-sectional scanning/transmission electron microscopy (XSEM/XTEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. In particular, in some embodiments, such tools may indicate a transistor structure having a nanoribbon stack that includes nanoribbons having different gate dielectric, dipole species, and/or gate metal. For example, XSEM/XTEM can be useful to show different material layers in the upper gate structure compared to the lower gate structure of a stacked transistor. In some embodiments, the techniques described herein may be detected based on the presence of a dipole species in the gate dielectric, as well as the benefits derived from the use of the techniques, which includes devices with more consistent threshold voltage, specific threshold voltage values, and different threshold voltage values between NMOS and PMOS devices. Numerous configurations and variations will be apparent in light of this disclosure.

### EXAMPLE STRUCTURES

FIG. 1 illustrates a cross-sectional view taken through the channel region of a stacked GAA transistor structure 100, in accordance with an embodiment of the present disclosure. The transistor structure 100 includes a first or lower device portion 130 and a second or upper device portion 150 above the lower device portion 130. The lower and upper device portions 130, 150 each include one or more body 112 of semiconductor material. In this example, the semiconductor bodies 112 are shaped as nanoribbons 110 and include layers of dielectric or other material. In this example, the lower device portion 130 and upper device portion 150 each has two nanoribbons 110 of a generally rectangular cross-sectional shape with a greater width than height. For example, the nanoribbon 110 can have a cross-sectional width that is at least twice the cross-sectional height. In some embodiments, the semiconductor body 112 can have a different aspect ratio or different cross-sectional shape and therefore may be described as a nanowire or nanosheet, as will be appreciated. For example, the semiconductor body 112 can have a circular, oval, elliptical, square, or other cross-sectional shape, and may be referred to as a nanowire.

The semiconductor material of the nanoribbons 110 can be silicon or other Group IV or Group III-V semiconductor material. In accordance with one embodiment, nanoribbons 110 in the lower device portion 130 are of p-type semiconductor material and nanoribbons 110 in the upper device portion 150 are of n-type semiconductor material, or vice versa. Such a configuration can be used in a CMOS circuit, for example.

A native oxide 114 is around the body 112 of semiconductor material. For example, the nanoribbon 110 comprises a silicon body 112 and the native oxide 114 includes silicon dioxide having a thickness of about 10 angstroms (Å). A high-κ dielectric 116 is on the native oxide 114 and surrounds the nanoribbons 110. The lower device portion 130 has a first high-κ dielectric 116a and nanoribbons 110 in the upper device portion 150 have a second high-κ dielectric 116b that is compositionally distinct from the first high-κ dielectric 116a. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, hafnium zirconium oxide, tantalum oxide, titanium oxide, barium strontium titanium oxide, barium titanium oxide, strontium titanium oxide, yttrium oxide, aluminum oxide, lead scandium tantalum oxide, and lead zinc niobate. The native oxide 114 of one or both device portions 130, 150 includes a diffused dipole species, such as aluminum, barium, cerium, chromium, cobalt, dysprosium, erbium, europium, gadolinium, gallium, holmium, lanthanum, lutetium, magnesium, manganese, molybdenum, neodymium, niobium, praseodymium, samarium, scandium, strontium, tantalum, terbium, thulium, titanium, ytterbium, or yttrium. As will be appreciated, the diffused dipole species is distinct from the high-k material. As noted above, the different high-κ dielectrics 116 can have different diffusion rates of the dipole species, resulting in different concentration of the dipole species at the interface between the native oxide 114 and the high-κ dielectric 116. In some embodiments, the sidewalls of the gate spacer (not shown) may exhibit residual amounts of the dipole species.

A gate conductor 120 is around each nanoribbon 110. In more detail, the gate conductor 120 wraps around each nanoribbon 110 such that the high-κ dielectric 116 and native oxide 114 are between the body 112 and the gate conductor 120. In this example, the gate conductor 120 is common to all nanoribbons 110 in the nanoribbon stack, where the gate conductor 120 is around individual nanoribbons 110 and also is around the nanoribbon stack as a whole. The gate conductor 120 can include one or more layers of conductive material, such as metal, work function metal or work function metal-containing material, and polysilicon. In some embodiments, the gate structure can include a diffusion barrier on the high-κ dielectric 116, such as niobium nitride, tantalum nitride, titanium nitride, or vanadium nitride. In some embodiments, the high-κ dielectric 116 can include multiple layers of dielectric material.

Referring now to FIG. 2, a cross-sectional view through the channel region of a stacked GAA transistor structure 100 shows a plurality of nanoribbons 110 in a lower device portion 130 and a plurality of nanoribbons 110 an upper device portion 150, in accordance with another embodiment of the present disclosure. In this example, nanoribbons 110 in the lower device portion 130 differ from nanoribbons 110 in the upper device portion 150 by having one or more of (i) compositionally distinct high-κ dielectric 116 materials, (ii) a different amount or concentration of diffused dipole species 118 (shown, e.g., in FIG. 3) at the interface with the native oxide 114, (iii) compositionally distinct materials of a diffusion barrier layer 119, (iv) difference in including or not including a diffusion barrier layer 119, and (v) compositionally distinct gate conductors 120.

Similar to the transistor structure 100 of FIG. 1, nanoribbons 110 in the lower and upper device portions 130, 150 include a native oxide 114 and a high-κ dielectric 116 on the native oxide 114. The native oxide 114 includes diffused dipole species 118, such as lanthanum, molybdenum, or cobalt, where the concentration of dipole species 118 is different in the lower device portion 130 than in the upper device portion 150. Nanoribbons 110 in the lower device portion 130 have a first high-κ dielectric 116a that is compositionally distinct from the second high-κ dielectric 116b in the upper device portion 150. In this example, nanoribbons 110 in both of the lower and upper device portions 130, 150 include a diffusion barrier layer 119 between the high-κ dielectric 116 and the gate conductor 120. One example material of a diffusion barrier layer 119 is tantalum nitride; other examples are noted above. The material of the diffusion barrier layer 119 can be different in the lower and upper device portions 130, 150.

In this example, a first gate conductor 120a is around the nanoribbons 110 of the lower device portion 130 and a second gate conductor 120b is around the nanoribbons 110 of the upper device portion 150, where the second gate conductor 120b is compositionally distinct from the first gate conductor 120a. For example, the first gate conductor 120a comprises one or more of cobalt, iridium, molybdenum, molybdenum nitride, nickel, palladium, platinum, ruthenium, titanium nitride, tungsten, or tungsten nitride, and the second gate conductor 120b comprises one or more of aluminum, scandium, tantalum, titanium, yttrium, or alloys thereof. In some such embodiments, the diffusion barrier layer 119 is different in the lower and upper device portions 130, 150, such that the lower device portion 130 has a first diffusion barrier layer 119a and the upper device portion 150 has a second diffusion barrier layer 119b. In other embodiments, one of the diffusion barrier layers 119a or 119b can be omitted. The transistor structure 100 may include an interlayer dielectric 122 between and isolating the first gate conductor 120a from the second gate conductor 120b. In other embodiments, the interlayer dielectric 122 is omitted and the first gate conductor 120a is in electrical communication with the second gate conductor 120b.

Referring now to FIG. 3, a cross-sectional view through the channel region of a stacked GAA transistor structure 100 shows nanoribbons 110 in a lower device portion 130 and an upper device portion 150, in accordance with another embodiment of the present disclosure. The transistor structure 100 of FIG. 3 includes a lower device portion 130 located below the upper device portion 150, each of which includes two nanoribbons 110. Nanoribbons 110 in the lower device portion 130 include a body 112 of semiconductor material, such as silicon or other suitable semiconductor material. A native oxide 114 is on the body 112 and a first high-κ dielectric 116a is on the native oxide 114.

Nanoribbons 110 of the upper device portion 150 include a body 112 of semiconductor material, such as silicon or other suitable semiconductor material. A native oxide 114 is on the body 112 and a second high-κ dielectric 116b is on the native oxide 114. Illustrated as a black line, a diffused dipole species 118 is present at the interface between the native oxide 114 and the second high-κ dielectric 116b. For example, the dipole species 118 is aluminum, barium, cerium, chromium, cobalt, dysprosium, erbium, europium, gadolinium, holmium, lanthanum, lutetium, magnesium, manganese, molybdenum, neodymium, niobium, praseodymium, samarium, scandium, strontium, terbium, thulium, titanium, ytterbium, or yttrium, and exhibits a peak concentration at the interface, with concentrations tapering in the adjacent native oxide 114 and second high-κ dielectric 116b. A diffusion barrier layer 119 (e.g., tantalum nitride) is between the second high-κ dielectric 116a and the gate conductor 120. In the example of FIG. 3, the gate conductor 120 is common to all nanoribbons 110 in the nanoribbon stack, where the gate conductor 120 is around individual nanoribbons 110 and also is around the nanoribbon stack as a whole.

Nanoribbons 110 in the upper device portion 150 further include a template material 124 (e.g., TiN) on the second high-κ dielectric, and include a diffusion barrier layer 119 (e.g., TaN) between the gate conductor 120 and the template material 124. In some embodiments, a residual layer of dipole species 118 (not shown) can be detected at the surface of the second high-κ dielectric 116b (e.g., a thickness of a few angstroms) as a result of fabricating the transistor structure 100. In other embodiments, the residual dipole species 118 and template material 124 is removed during annealing or post-anneal cleaning. Unlike the nanoribbons 110 of the upper device portion 150, nanoribbons 110 of the lower device portion 130 lack the template material, diffusion barrier layer 119, and dipole species 118.

Referring now to FIG. 4, a cross-sectional view taken through the channel region of a stacked GAA transistor structure 100 shows nanoribbons in lower and upper device portions 130, 150 of the transistor structure 100, in accordance with another embodiment of the present disclosure. The transistor structure 100 of FIG. 4 is similar to that of FIG. 3, except that the lower device portion 130 has a first gate conductor 120a and the upper device portion 150 has a second gate conductor 120b that is compositionally distinct from the first gate conductor 120a.

### METHOD OF FABRICATION

Turning now to FIG. 5, a flowchart illustrates a method 500 of gate processing for a stacked GAA transistor structure 100, in accordance with an embodiment of the present disclosure. Processes in method 500 can be performed using any suitable techniques, including blanket deposition techniques, atomic layer deposition (ALD), wet and dry etching processes, and/or any other suitable techniques as will be apparent in light of this disclosure. Although processes in method 500 are described in the context of processing nanoribbons in a stacked nanoribbon transistor structure, variations of method 500 can be implemented to process gate structures of other semiconductor bodies, including nanoribbon and nanosheet transistors, forksheet transistors, planar transistors, FinFETs, and TFETs.

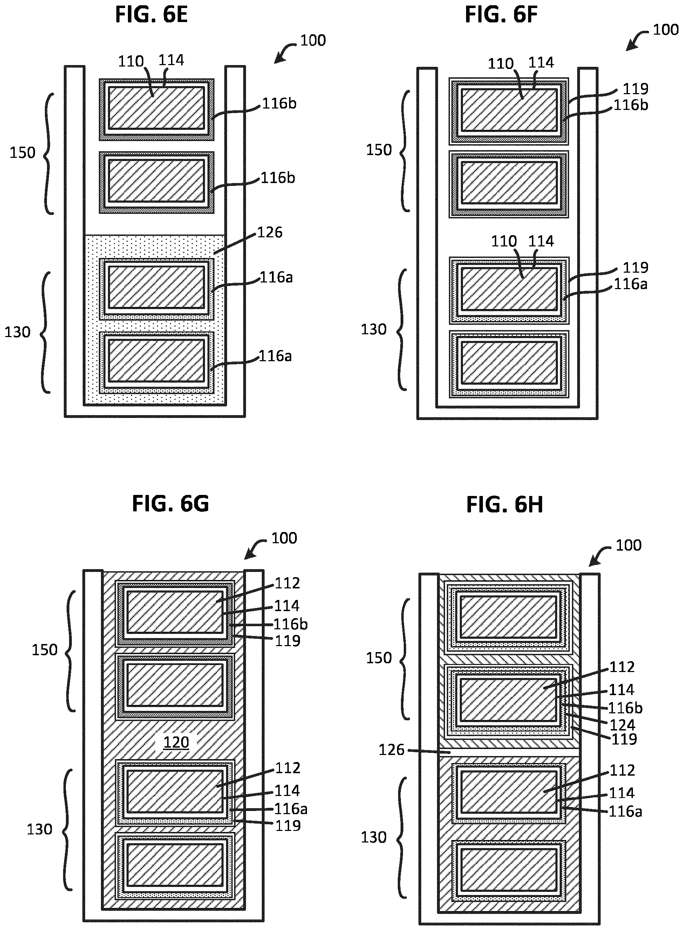

Method 500 will be described concurrently with reference to FIGS. 6A-6H, which illustrate cross-sectional views taken through the semiconductor bodies (e.g., channel region) of a nanoribbon stack at various stages of processing, in accordance with some embodiments. Note that example transistor structures 100 of FIGS. 6A-6H do not necessarily follow a single process flow. For example, the transistor structure 100 of FIG. 6H includes material layers in the upper device portion 150 that are not present in the transistor structure 100 of FIG. 6G. As such, the transistor structure of FIG. 6H would not normally result from additional processing of the transistor structure 100 of FIG. 6G. In the FIGS. 6A-6H, the semiconductor bodies are illustrated as having a cross-sectional width that is about twice the height; accordingly, semiconductor bodies may be referred to as nanoribbons, in some embodiments. The semiconductor bodies can have a cross-sectional height from 2-15 nm or about 5-12 nm, and a width of 5-35 nm, including 8-25 nm, for example. Vertical spacing between semiconductor bodies is typically from 5 to 50 nm, including 5-30 nm, 5-15 nm, and 5-10 nm. In some instances, vertical spacing is 5-10 nm. Regardless of the cross-sectional shape, the semiconductor bodies will be referred to as nanoribbons in describing method 500. However, method 500 is not limited to nanoribbons and can be used for processing stacked GAA transistors that include nanowires, nanosheets, or other semiconductor bodies.

Method 500 begins with providing 505 a stacked GAA transistor structure having a first or lower device portion and a second or upper device portion. The lower and upper device portions each include at least one semiconductor body (e.g., nanoribbon, nanosheet, or nanowire), where the semiconductor bodies of the transistor structure extend in parallel and are arranged one above another in a spaced-apart, vertical stack. In one embodiment in which the semiconductor bodies are nanoribbons, each of the lower and upper device portions includes one, two, three, four, six, eight, ten, or some other number of nanoribbons. Semiconductor bodies of the lower device portion can be of a first polarity (e.g., n-type semiconductor material) and semiconductor bodies of the upper device portion can be of a second polarity (e.g., p-type semiconductor material), or vice versa. In some embodiments, semiconductor bodies in the lower and upper device portions have consistent vertical spacing between semiconductor bodies in a given device portion. Also, the lower device portion as a whole can be spaced from the upper device portion by a distance that is greater than vertical spacing between adjacent semiconductor bodies in either device portion of the nanoribbon stack. For example, the lower and upper device portions are spaced by a vertical distance between topmost body of the lower device portion and bottom-most body of the upper device portion, where this vertical spacing can be the greater than spacing between individual bodies. Such additional spacing between the lower and upper device portions is not required but can facilitate different processing for each group of semiconductor bodies, in accordance with some embodiments.

FIG. 6A illustrates a cross-sectional view taken through the channel portion of a stacked GAA transistor structure 100 having a vertical stack of nanoribbons 110 that includes a lower device portion 130 positioned vertically below an upper device portion 150. The lower and upper device portions 130, 150 each have two nanoribbons 110 in this example; other numbers of nanoribbons 110 can be used. The nanoribbons 110 are shown in a trench 104 formed in an interlayer dielectric 122. For simplicity of illustration, not all surrounding structure is illustrated. The nanoribbons 110 can be of any suitable semiconductor material. In one example, the nanoribbons 110 are fabricated from silicon.

In some embodiments, providing 505 the transistor structure includes fabricating the stack of semiconductor bodies, which may include blanket deposition of alternating semiconductor material layers to define a layer stack on a base or substrate, etching the layer stack to define one or more fins, depositing a dummy gate and gate spacer over the fins, and source/drain processing. In one embodiment, the source/drain portions of the devices can be processed by depositing isolation material and recessing the isolation material to expose ends of the nanoribbon channel regions, and epitaxial growth of source/drain material. After source/drain processing, semiconductor bodies (e.g., nanoribbons) can be released using a selective etch process that preferentially etches one material in the layer stack far faster than the other material. The released semiconductor bodies can be cleaned and shaped as needed in preparation for gate processing.

In one embodiment of fabricating the nanoribbon stack, providing 505 the transistor structure begins with providing a semiconductor substrate. The substrate may include any suitable material, such as monocrystalline semiconductor material that includes at least one of silicon (Si), germanium (Ge), carbon (C), tin (Sn), phosphorous (P), boron (B), arsenic (As), antimony (Sb), indium (In), and gallium (Ga) to name a few examples. In some embodiments, the substrate is bulk silicon, such as monocrystalline silicon in wafer form. In other embodiments, the substrate can be any suitable semiconductor material, including silicon, silicon carbide (SiC), gallium nitride (GaN), and gallium arsenide (GaAs) to name a few examples. The substrate can be selected in some embodiments from III-V materials and group IV materials. Further, the substrate can comprise a semiconductor material layer deposited or grown on a structural support medium. In one particular embodiment, the substrate is selected to have a (100) lattice structure in a horizontal plane of the substrate and a (110) lattice structure in a vertical plane forming a sidewall of the nanoribbons.

In some embodiments, the substrate may be doped with any suitable n-type and/or p-type dopant at a dopant concentration in the range of 1E16 to 1E22 atoms per cubic cm, for example. For instance, a silicon substrate can be p-type doped using a suitable acceptor (e.g., boron) or n-type doped using a suitable donor (e.g., phosphorous, arsenic) with a doping concentration of at least 1E16 atoms per cubic cm. However, in some embodiments, the substrate may be undoped/intrinsic or relatively minimally doped (such as including a dopant concentration of less than 1E16 atoms per cubic cm), for example. In some embodiments, the substrate is a substrate consisting essentially of Si, such as electronic grade silicon. In other embodiments, the substrate may primarily include Si but may also include other material (e.g., a dopant at a given concentration). Also, note that the substrate may include relatively high quality or device-quality monocrystalline Si or other material that provides a suitable template or seeding surface from which other monocrystalline semiconductor material features and layers can be formed. Therefore, unless otherwise explicitly stated, a substrate 110 as described herein is not intended to be limited to a substrate that only includes Si.

In some embodiments, the substrate may have a crystalline orientation described by a Miller index of (100), (110), or (111), or its equivalents, as will be apparent in light of this disclosure. The substrate may be relatively much thicker than the other layers, such as having a thickness in the range of 1 to 950 microns (or in the sub-range of 20 to 800 microns), for example, or any other suitable thickness or range of thicknesses as will be apparent in light of this disclosure. The substrate may include a multilayer structure including two or more distinct layers that may or may not be compositionally different. In some embodiments, the substrate may include grading (e.g., increasing and/or decreasing) of one or more material concentrations throughout at least a portion of the material. In some embodiments, the substrate may be used for one or more other IC devices, such as diodes (e.g., light-emitting diodes (LEDs) or laser diodes), transistors (e.g., MOSFETs or TFETs), capacitors (e.g., MOSCAPs), microelectromechanical systems (MEMS), nanoelectromechanical systems (NEMS), radio frequency (RF) devices, sensors, or any other suitable semiconductor or IC devices, depending on the end use or target application. Accordingly, in some embodiments, the structures described herein may be included in a system-on-chip (SoC) application, as will be apparent in light of this disclosure.

Fabricating the nanoribbon stack continues with depositing a layer stack on the substrate (or on the buffer, when present). The layer stack has alternating layers of a sacrificial material and channel material, in accordance with some embodiments. In one embodiment, alternating blanket layers of sacrificial material and channel material can be formed using layer-by-layer epitaxial growth, where the sacrificial material can subsequently be removed to release semiconductor bodies of the channel material. In one example embodiment, the sacrificial material is silicon germanium (SiGe) and the channel material is silicon (Si) or vice versa. In another embodiment that utilizes a buffer, the sacrificial material is indium gallium arsenide (InGaAs) and the channel material is indium phosphide (InP). Other pairs of sacrificial material and channel material can be used, as will be appreciated. In some cases, the channel material can be doped during epitaxy with a suitable dopant at a desired concentration, as will be appreciated.

The layer stack can be formed using any suitable techniques, such as one or more deposition or epitaxial growth processes (e.g., CVD, PVD, ALD, VPE, MBE, LPE), melt regrowth, and/or any other suitable processing, as will be appreciated in light of the present disclosure. In some embodiments, the sacrificial material and the channel material are deposited as blanket layers and may include a buffer layer between the substrate and the first layer of the layer stack. Additional processing can be performed after depositing each layer as needed, such as cleaning and polishing one material prior to deposition of the next material. In some embodiments, a given material of the layer stack has a vertical thickness (dimension in the Z-axis direction) in the range of 2 nm to 30 nm (or in a subrange of 2-20, 5-30, 5-25, 5-20, 5-15, 5-10, 10-20, 15-30, 15-20, and 20-30) and/or a maximum vertical thickness of at most 30, 25, 20, 15, 10, or 5 nm, for example. Other vertical thickness requirements or thresholds can be used, as will be apparent in light of this disclosure. The vertical thickness of each layer can be selected to provide the desired geometry of the semiconductor body to be subsequently formed. The materials in the layer stack need not have the same vertical thickness from layer to layer nor among layers of a given material. For example, the thickness (in the Z-axis direction) of a given layer can be controlled to provide the desired geometry or vertical spacing between nanowires or other semiconductor bodies to be formed.

In some embodiments employing multiple different channel materials, one channel material may include Group IV semiconductor material (e.g., Si, SiGe, Ge, etc.) and another channel material may include Group III-V semiconductor material (e.g., GaAs, InGaAs, InP, etc.). In general, a given channel material may include monocrystalline Group IV semiconductor material and/or Group III-V semiconductor material.

Fabricating the nanoribbon stack continues with defining fins from the layer stack, in accordance with some embodiments. In one example, regions of the layer stack to be processed into fins are masked, followed by etching the surrounding regions to define one or more fins. For instance, an anisotropic etch proceeds substantially vertically (e.g., ±5°) through the layer stack to define isolation trenches between adjacent fins. In some embodiments, the etch process proceeds into the substrate to define a fin that includes a subfin portion of substrate material and/or buffer material (when present). Above the subfin portion, the fin has alternating layers of sacrificial material and channel material as deposited in the layer stack. In some embodiments, the etch process defines groups of parallel fins extending vertically up from the substrate. In some embodiments, each fin may include a horizontal fin width (dimension in the X-axis direction) in the range of 2-50 nm (or in a subrange of 2-5, 2-10, 5-10, 5-20, 5-30, 5-50, 10-20, 10-30, 10-50, 20-30, 20-50, or 30-50 nm) and/or a maximum horizontal fin width of at most 50, 30, 20, 10, or 5 nm, for example.

Fabricating the nanoribbon stack continues with defining a dummy gate structure in contact with the top and sides of each fin. Dummy gate processing can be performed in accordance with a gate-last process flow, processes of method 500 are performed after source/drain processing. In one embodiment, dummy gate processing includes initially filling trenches between the fins with shallow trench isolation (STI) material, planarizing/polishing the structure (e.g., via CMP), and recessing the polished STI material to expose the layer stack portion of the fins above the subfin portion. In some embodiments, deposition of the STI material may include any suitable deposition techniques, such as those described herein (e.g., CVD, ALD, PVD), or any other suitable deposition process. In some embodiments, STI material may include any suitable electrical insulator material, such as one or more dielectric, oxide (e.g., silicon dioxide), and/or nitride (e.g., silicon nitride) materials. In some embodiments, the STI material may be selected based on the material of the substrate. For example, the STI material may be selected from silicon dioxide or silicon nitride based on the use of a Si substrate.

In accordance with some embodiments, the dummy gate structure includes a dummy gate electrode, gate spacers, and a hardmask. The dummy gate electrode can be made of polysilicon or other suitable material, as will be appreciated. The dummy gate structure can define the channel region and source/drain regions of each fin, where the channel region is under the dummy gate structure and the source and drain regions are on either side of the dummy gate structure and connect to the channel region.

Dummy gate processing includes forming gate spacers on opposite sides of the dummy gate electrode. The gate spacers may include any suitable material, such as any suitable electrical insulator, dielectric, oxide (e.g., silicon oxide), and/or nitride (e.g., silicon nitride) material, as will be apparent in light of this disclosure. In one embodiment, the gate spacers are formed of silicon nitride (Si₃N₄). Note that in some embodiments, a hardmask may be formed over the dummy gate structure to protect the dummy gate electrode and gate spacers during subsequent processing, for example. In some embodiments, the hardmask is formed on top of the dummy gate electrode between the gate spacers.

Fabricating the nanoribbon stack continues with processing the source/drain regions using any suitable techniques, in accordance with an embodiment of the present disclosure. In one embodiment, source/drain processing is performed according to a replacement source/drain approach, which includes recessing at least a portion of the exposed source and drain regions of the fins. In some embodiments, all of the layer stack is removed in the source and drain regions of the fin, in addition to some amount of the substrate or other material below the layer stack. In other embodiments, the etch process stops short of completely removing the entire layer stack, leaving behind a stub or residual portion of the layer stack in the source/drain region. For example, the stub is part of a bottom or first layer of sacrificial material. The source/drain etch exposes ends of the nanoribbon channel material at the outside surface of the gate spacers. The resulting structure may be masked as needed for deposition or growth of replacement source/drain material, as discussed in more detail below. In other embodiments, source and drain processing does not recess or does not fully recess the layer stack in the source/drain regions of the fins; instead, the material in the layer stack at the source/drain regions is converted to final source/drain by doping, implantation, and/or cladding with a source/drain material or other suitable processing, for example.

Processing the source and drain of the lower device portion may be performed first, followed by processing the source and drain of the upper device portion. For example, source/drain processing includes depositing a layer of STI material (e.g., an oxide (e.g., SiO₂)), followed by recessing the STI to the top of the lower device section. Another isolation material (e.g., a nitride (e.g., Si₃N₄)) can then be deposited conformally over the STI material and the exposed portion of the upper device section. The STI material is then removed in the lower device section, such as by a wet etch process, leaving the isolation material (e.g., Si₃N₄) on the faces of the gate spacers and over the ends of the channel material. By removing the STI material in the lower device section, the channel material at the face of the gate spacer is now exposed for epitaxial growth of replacement source/drain material.

Source/drain processing continues with epitaxially growing replacement source/drain material using any suitable techniques, such as vapor-phase epitaxy (VPE), molecular beam epitaxy (MBE), or liquid-phase epitaxy (LPE), for example. In a stacked transistor configuration, for example, material of the source and drain regions in the lower device section can be epitaxially grown laterally from the channel material exposed at the gate spacer. For example, single-crystal material grows hemispherically outward from the exposed ends of the channel material. After processing the source/drain in the lower device section, a layer of STI material can be deposited over the source/drain of the lower device section in preparation for processing the source/drain in the upper device section. In some cases, an isolation material can be deposited on the STI material, such as an oxide (e.g., SiO₂), nitride (e.g., Si₃N₄), a low-k dielectric (e.g., porous SiO₂ or material having a dielectric constant κ below 3.9), alumina, oxynitride compounds, carbonoxynitride compounds, a spin-on C-rich glass, or some other electrically insulating material. The isolation material deposited on top of the lower device section is generally different from that used in the upper device section to allow selective etching of one of the isolation materials. Isolation material (e.g., Si₃N₄) on the gate spacers in the upper device section is removed to expose the channel material in the upper device section. Replacement source/drain material can then be epitaxially grown from the exposed ends of the channel material 138 in the upper device section.

In some embodiments, the source and drain may be formed one polarity at a time, such as processing one of n-type and p-type source/drain, and then processing the other of the n-type and p-type source/drain. In some embodiments, the source and drain may include any suitable doping scheme, such as including suitable n-type and/or p-type dopant (e.g., in a concentration in the range of 1E16 to 1E22 atoms per cubic cm). However, in some embodiments, at least one source or drain may be undoped/intrinsic or relatively minimally doped, such as including a dopant concentration of less than 1E16 atoms per cubic cm, for example.

Fabricating the nanoribbon stack continues with releasing nanoribbons in the channel region, which can be performed in both the upper device section and lower device section at the same time. In other embodiments, such as embodiments having different channel materials in the lower and upper device portions, releasing the nanoribbons is performed in a multistep process where the lower device section is processed separately from the upper device section, as will be appreciated.

Releasing the nanoribbons may begin with removing the dummy gate electrode between the gate spacers to expose the channel region of each fin. For example, a dummy gate electrode of polycrystalline silicon can be removed using a wet etch process (e.g., nitric acid/hydrofluoric acid), an anisotropic dry etch, or other suitable etch process, as will be appreciated. After removing the dummy gate electrode, the fin-shaped layer stack of alternating layers of channel material and sacrificial material is exposed in the channel region between the gate spacers. The channel region of the layer stack extends between and contacts the source and drain, where ends of the layer stack are protected by the gate spacers. The sacrificial material can be removed by etch processing, such as an etch process that is selective to remove the sacrificial material (e.g., SiGe) in the layer stack, while leaving intact the channel material (e.g., Si) to define nanoribbons.

Etching the sacrificial material may be performed using any suitable wet or dry etching process such that the etch process selectively removes the sacrificial material and leaves intact the channel material. After removing the sacrificial material, the resulting channel region includes semiconductor bodies-in this case, nanoribbons-that extend between the epitaxial material of the source and drain, where ends of the nanoribbons (e.g., Si) contact the source and drain and remain at least partially protected by the gate spacers wrapping around them.

The released nanoribbons may be cleaned and/or shaped using a series of oxide formation and etchback, as will be appreciated. For example, a thin surface oxide can be formed using thermal oxidation, deposition of an oxide plus annealing, or other suitable process. A wet or dry etch process can then be used to remove the oxide. Such a sequence of oxidation and oxide removal can remove residual amounts of the sacrificial material and other impurities on the channel material. Such cleaning and shaping process can also be useful to round corners of the nanoribbon cross section, thereby reducing areas of charge accumulation.

Method 500 continues with depositing or growing 510 an oxide on the semiconductor material in the channel region of the nanoribbon stack. In one embodiment, the oxide is native to the semiconductor material of the nanoribbons, grown by exposing the nanoribbons to an oxidizing environment. In one embodiment, the nanoribbons are exposed to ozone gas at room temperature or at an elevated temperature to grow a native oxide with a thickness of about 10Å. In other embodiments, the oxide can be deposited by atomic layer deposition or other suitable method. The oxide can have a thickness from about 2-15 Å, including 8-12 Å, or about 10Å, in accordance with some embodiments. FIG. 6B illustrates the nanoribbon stack of FIG. 6A after growing a native oxide 114 on the nanoribbons 110.

Method 500 continues with depositing 515 a high-κ dielectric on the oxide or directly on the exposed nanoribbons in the channel region. The high-κ dielectric may include, for example, any suitable oxide (such as silicon dioxide), high-k dielectric material, and/or any other suitable material as will be apparent in light of this disclosure. Examples of high-κ dielectric materials include, for instance, hafnium oxide, hafnium silicon oxide, lanthanum oxide, lanthanum aluminum oxide, zirconium oxide, zirconium silicon oxide, hafnium zirconium oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In one embodiment, the high-κ dielectric can be deposited using atomic layer deposition (ALD) or other suitable technique. The high-κ dielectric typically has a thickness from about 1-5 nanometers; other thicknesses can be used as suitable for a particular application. FIG. 6C illustrates the nanoribbon stack of FIG. 6B after depositing a high-κ dielectric 116 on the native oxide 114 of nanoribbons 110 in the lower device portion 130 and in the upper device portion 150.

In some embodiments, the deposited high-κ dielectric on nanoribbons in the lower device portion is a first high-κ dielectric. In one such embodiment, process 515 includes subsequently removing the first high-κ dielectric from nanoribbons in the upper device portion and depositing a second high-κ dielectric on the nanoribbons in the upper device portion. Process 515 may include depositing an isolation material over the nanoribbons in the lower device portion to protect the nanoribbons during high-κ dielectric processing in the upper device portion. The isolation material can then be removed and cleaning processes performed, as needed. Numerous variations and embodiments will be apparent in light of the present disclosure.

In FIG. 6D, isolation material 126 has been deposited over the nanoribbons 110 and then recessed to protect the nanoribbons 110 in the lower device portion 130. The first high-κ dielectric has been removed from nanoribbons in the upper device portion 150. In FIG. 6E, a second high-κ dielectric 116b has been deposited on nanoribbons 110 in the upper device portion 150; the first high-κ dielectric 116a remains on the nanoribbons in the lower device portion 130, protected by the isolation material 126. The isolation material 126 can be removed as needed for subsequent processing.

In some embodiments, method 500 may continue with depositing 520 a layer of titanium nitride (TiN) or other suitable template material on the high-κ dielectric. In one embodiment, process 520 can be performed after the high-κ dielectric has been deposited on nanoribbons in the lower and upper device portions, but prior to removal of the isolation material. As such, the template material can be deposited only onto nanoribbons of the upper device portion, followed by removing the isolation material to result in one group of nanoribbons having a high-κ dielectric and the other group of nanoribbons having a high-κ dielectric and a layer of template material on the high-κ dielectric. In other embodiments, the template material, such as molybdenum nitride, niobium nitride, titanium nitride, tungsten nitride, or vanadium nitride, can be deposited on the high-κ dielectric in both the lower and upper device portions, where it can function as an adhesion material for the dipole species.

Method 500 continues with depositing 530 a dipole species on some or all of the nanoribbons in the nanoribbon stack. In some embodiments, the dipole species is deposited 525 on nanoribbons in both of the lower and upper device portions. In other embodiments, such as when the template material is deposited onto the high-κ dielectric of nanoribbons only in the upper device portion, the dipole species is selectively deposited 525 on the template material of those nanoribbons. In one such embodiment, prior to removing the isolation material that protects the nanoribbons in the lower device portion, the dipole species is deposited on the template material (e.g., TiN) on nanoribbons in the upper device portion. In other embodiments, the dipole species (or an oxide thereof) preferentially deposits on the template material and thus can be deposited selectively onto nanoribbons having the template material, and not deposited or minimally deposited onto nanoribbons lacking the template material. Examples of suitable dipole species compounds include oxides of the dipole species, namely, aluminum oxide (e.g., Al₂O₃), barium oxide (e.g., BaO), cerium oxide (e.g., Ce₂O₃, CeO₂), chromium oxide (e.g., Cr₂O₃, CrO₂), cobalt oxide (e.g., CoO, Co₂O₃, Co₃O₄), dysprosium oxide (e.g., Dy₂O₃), erbium oxide (e.g., Er₂O₃), europium oxide (e.g., Eu₂O₃), gadolinium oxide (e.g., Gd₂O₃), gallium oxide (e.g., Ga₂O₃) holmium oxide (e.g., Ho₂O₃), lanthanum oxide (e.g., La₂O₃), lutetium oxide (e.g., Lu₂O₃), magnesium oxide (e.g., MgO), manganese oxide (e.g., MnO, Mn₂O₃, Mn₃O₄, MnO₂, Mn₂O₇), molybdenum oxide (e.g., MoO₂, MoO₃), neodymium oxide (e.g., Nd₂O₃), niobium oxide (e.g., NbO₂, Nb₂O₅), praseodymium oxide (e.g., Pr₂O₃), samarium oxide (e.g., Sm₂O₃), scandium oxide (e.g., Sc₂O₃), strontium oxide (e.g., SrO), tantalum oxide (e.g., Ta₂O₅), terbium oxide (e.g., Tb₂O₃), thulium oxide (e.g., Tm₂O₃), titanium oxide (e.g., TiO₂), or ytterbium oxide (e.g., Yb₂O₃), yttrium oxide (e.g., Y₂O₃), and alloys thereof. In some embodiments, the dipole species is a deposited in a thin film having a thickness of 1 nm or less. For example, the dipole species layer is a monolayer or plurality of monolayers having a thickness of not more than 10 angstroms (Å), including a thickness of 1-10Å, 1-5Å, 1-3Å and about 2-4 Å.

Method 500 continues with annealing 530 the dipole species, causing the metal of the dipole species to diffuse to or towards the interface between the oxide and the high-κ dielectric. In some embodiments, annealing 530 occurs at a temperature of greater than 700°C for up to 30 seconds. In some embodiments, annealing 530 is a multi-step process that includes a first anneal performed for about 30 seconds in an ammonia atmosphere at a temperature of about 600-800°C. For example, the first anneal is performed to increase the density of at least some materials. A second anneal can be a flash anneal that is performed for several milliseconds at a temperature of 1000-1200°C, such as about 1100°C. Annealing 530 can be performed and tuned so as to cause the dipole species (e.g., La, Mo, or Co) to diffuse through the high-κ dielectric to the interface with the native oxide, but not beyond.

As needed, method 500 may include cleaning residual dipole species, buffer materials, and/or other materials, as necessary or desired. In one embodiment, oxygen from the dipole species and the template material are removed during the annealing process. However, an acid etch or other suitable process can be used to remove residual materials from the dipole species and template material (when present).

Method 500 may include depositing 535 a diffusion barrier. In one embodiment, the diffusion barrier is niobium nitride, tantalum nitride, titanium nitride, vanadium nitride, or other suitable material. The diffusion barrier is deposited over the high-κ dielectric after annealing, and prior to deposition of the gate conductor, in some embodiments. The diffusion barrier material can be selected depending on the choice(s) of gate conductor, as will be appreciated.

FIG. 6F illustrates the transistor structure 100 after annealing 530 the dipole species, cleaning, and deposition 535 of a diffusion barrier layer 119. In this example, the native oxide 114 is rich in dipole species (e.g., lanthanum, molybdenum, or cobalt). However, since the nanoribbons in the lower device portion 130 have a first high-κ dielectric 116a and the nanoribbons in the upper device portion 150 have a different, second high-κ dielectric 116b, the concentration of the dipole species is different in the lower and upper device portions 130, 150. Nanoribbons in both the lower and upper device portions 130, 150 include a diffusion barrier layer 119 in this example.

Method 500 continues with depositing 540 one or more gate conductors. The gate conductor can include a work function metal in addition to a gate electrode in a multi-layer process, in accordance with some embodiments. The gate conductor(s) can be deposited using a chemical vapor deposition (CVD) process or other suitable process. In some embodiments, nanoribbons in the lower and upper device portions have the same gate conductor. In other embodiments, the lower device portion has a first gate conductor and the upper device portion has a different second gate conductor. In one such embodiment, the first gate conductor is deposited, followed by recessing to a level below the nanoribbons in the upper device portion. The second gate conductor is then deposited in the upper device portion. In some embodiments, a layer of isolation material is deposited on the first gate conductor prior to depositing the second gate conductor, such that the first and second gate conductors are electrically isolated from one another.

A work function layer (e.g., a work function metal or work function metal-containing compound) can be deposited over the high-κ dielectric in a relatively thin layer using an atomic layer deposition process or any other suitable process. In some embodiments, the work function layer has a thickness from 1 nm to 15 nm (e.g., 2 nm to 6 nm, 2 nm to 5 nm, 4 nm to 8 nm, or 5 nm to 10 nm). For example, the work function layer has a thickness of one to five nm and defines a layer that wraps around each nanoribbon. In other embodiments, the work function layer is deposited in a greater amount to define a continuous layer around and between adjacent nanoribbons. When the vertical spacing between nanoribbons is sufficiently small, the process conditions of atomic layer deposition or other deposition technique can be performed such that the work function layer closes on itself.

A gate electrode can subsequently be deposited over the work function layer. Any suitable technique can be used, such as CVD deposition. The gate electrode may include polysilicon or various suitable metals or metal alloys, such as cobalt, iridium, molybdenum, molybdenum nitride, nickel, palladium, platinum, ruthenium, titanium nitride, tungsten, or tungsten nitride, aluminum, scandium, tantalum, titanium, yttrium, or alloys thereof.

FIG. 6G illustrates a transistor structure 100 after depositing a gate conductor 120 that is common to the lower device portion 130 and the upper device portion 150 and surrounds each nanoribbon in the nanoribbon stack, in accordance with one embodiment. Nanoribbons in the lower device portion 130 have a body 112 or channel region of semiconductor material, a native oxide 114 on the body 112 that includes diffused dipole species, a first high-κ dielectric 116a on the native oxide 114, and a diffusion barrier layer 119 on the first high-κ dielectric 116a. Similarly, nanoribbons in the upper device portion 150 have a body 112 or channel region of semiconductor material, a native oxide 114 on the body 112 that includes diffused dipole species, a second high-κ dielectric 116b on the native oxide 114, and a diffusion barrier layer 119 on the second high-κ dielectric 116a. The first and second high-κ dielectrics 116a, 116b are compositionally distinct. As a result, the diffused dipole species is present at the interface between the native oxide 114 and the high-κ dielectric 116 in different amounts or concentrations in the lower and upper device portions 130, 150.

FIG. 6H illustrates a transistor structure 100 after depositing a first gate conductor 120a in the lower device portion 130 and depositing a second gate conductor 120b in the upper device portion 150, in accordance with another embodiment of the present disclosure. In this example, the first gate conductor 120a is compositionally distinct from the second gate conductor 120b. In addition, the first gate conductor 120a is electrically isolated from the second gate conductor 120b by isolation material 126. As discussed above, the isolation material 126 between the first and second gate conductors 120a, 120b can be omitted in some embodiments, depending on the intended application.

Nanoribbons in the lower device portion 130 have a body 112 or channel region of semiconductor material, a native oxide 114 on the body that includes diffused dipole species, and a first high-κ dielectric 116a on the native oxide 114. The first gate conductor 120a wraps around the first high-κ dielectric 120a. In contrast, nanoribbons in the upper device portion 150 have a body 112 or channel region of semiconductor material, a native oxide 114 on the body that includes diffused dipole species, a second high-κ dielectric 116b on the native oxide 114, a residual layer of template material 124 (e.g., TiN), and a diffusion barrier layer 119 (e.g., TaN) on the second high-κ dielectric 116a. The first and second high-κ dielectrics 116a, 116b are compositionally distinct. As a result, the diffused dipole species is present at the interface between the native oxide 114 and the high-κ dielectric 116 in different amounts or concentrations in the lower and upper device portions 130, 150.

Method 500 continues with forming 545 source/drain contacts for the transistor structure. In some embodiments, the source and drain contacts can be formed using any suitable techniques, such as forming vias in an ILD layer extending vertically down to the respective source/drain regions, followed by depositing metal or metal alloy (or other suitable electrically conductive material) in the vias. In some embodiments, forming source/drain contacts may include silicidation, germanidation, III-V-idation, and/or annealing processes, for example.

In some embodiments, the source and drain contacts may include aluminum or tungsten, although any suitable conductive metal or alloy can be used, such as silver, nickel-platinum, or nickel-aluminum, for example. In some embodiments, one or more of the source and drain contacts may include a resistance reducing metal and a contact plug metal, or just a contact plug, for instance. Example contact resistance reducing metals include, for instance, nickel, aluminum, titanium, gold, gold-germanium, nickel-platinum, nickel aluminum, and/or other such resistance reducing metals or alloys. Example contact plug metals include, for instance, aluminum, copper, nickel, platinum, titanium, or tungsten, or alloys thereof, although any suitably conductive contact metal or alloy may be used. In some embodiments, additional layers may be present in the source and drain contact regions, such as adhesion layers (e.g., titanium nitride) and/or barrier layers (e.g., tantalum nitride), if so desired. In some embodiments, a contact resistance-reducing layer may be present between a given source or drain region and its corresponding source or drain contact, such as a relatively highly doped (e.g., with dopant concentrations greater than 1E18, 1E19, 1E20, 1E21, or 1E22 atoms per cubic cm) intervening semiconductor material layer, for example. In some such embodiments, the contact resistance reducing layer may include semiconductor material and/or impurity dopants based on the included material and/or dopant concentration of the corresponding source or drain region, for example.

Method 500 continues with completing 550 a general integrated circuit (IC) as desired, in accordance with some embodiments. Such additional processing to complete an IC may include back-end or back-end-of-line (BEOL) processing to form one or more metallization layers and/or interconnect in contact with the transistor devices formed, for example. Any other suitable processing may be performed, as will be apparent in light of this disclosure. Note that the processes in method 500 are shown in a particular order for ease of description. However, one or more of the processes may be performed in a different order or may not be performed at all, in accordance with some embodiments. Numerous variations on method 500 and the techniques described herein will be apparent in light of this disclosure.

### EXAMPLE SYSTEM

FIG. 7 is an example computing system implemented with one or more of the integrated circuit structures as disclosed herein, in accordance with some embodiments of the present disclosure. As can be seen, the computing system 1000 houses a motherboard 1002. The motherboard 1002 may include a number of components, including, but not limited to, a processor 1004 and at least one communication chip 1006, each of which can be physically and electrically coupled to the motherboard 1002, or otherwise integrated therein. As will be appreciated, the motherboard 1002 may be, for example, any printed circuit board, whether a main board, a daughterboard mounted on a main board, or the only board of system 1000, etc.

Depending on its applications, computing system 1000 may include one or more other components that may or may not be physically and electrically coupled to the motherboard 1002. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1000 may include one or more integrated circuit structures or devices configured in accordance with an example embodiment (e.g., to include stacked GAA transistor structures, as variously provided herein). In some embodiments, multiple functions can be integrated into one or more chips (e.g., for instance, note that the communication chip 1006 can be part of or otherwise integrated into the processor 1004).

The communication chip 1006 enables wireless communications for the transfer of data to and from the computing system 1000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1006 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1000 may include a plurality of communication chips 1006. For instance, a first communication chip 1006 may be dedicated to shorter range wireless communications such as Wi-Fi and Bluetooth and a second communication chip 1006 may be dedicated to longer range wireless communications such as GPS, EDGE, GPRS, CDMA, WiMAX, LTE, Ev-DO, and others. In some embodiments, communication chip 406 may include one or more transistor structures having a gate stack an access region polarization layer as variously described herein.

The processor 1004 of the computing system 1000 includes an integrated circuit die packaged within the processor 1004. In some embodiments, the integrated circuit die of the processor includes onboard circuitry that is implemented with one or more integrated circuit structures or devices as variously described herein. The term "processor" may refer to any device or portion of a device that processes, for instance, electronic data from registers and/or memory to transform that electronic data into other electronic data that may be stored in registers and/or memory.

The communication chip 1006 also may include an integrated circuit die packaged within the communication chip 1006. In accordance with some such example embodiments, the integrated circuit die of the communication chip includes one or more integrated circuit structures or devices as variously described herein. As will be appreciated in light of this disclosure, note that multi-standard wireless capability may be integrated directly into the processor 1004 (e.g., where functionality of any chips 1006 is integrated into processor 1004, rather than having separate communication chips). Further note that processor 1004 may be a chip set having such wireless capability. In short, any number of processor 1004 and/or communication chips 1006 can be used. Likewise, any one chip or chip set can have multiple functions integrated therein.

In various implementations, the computing system 1000 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

### FURTHER EXAMPLE EMBODIMENTS

The following examples pertain to further embodiments, from which numerous permutations and configurations will be apparent.

Example 1 is an integrated circuit comprising a lower device portion including first body of semiconductor material extending horizontally between first source and drain regions; a first gate structure around the first body, the first gate structure including a first gate electrode and a first gate dielectric, the first gate dielectric between the first body and the first gate electrode; an upper device portion above the lower device portion, the upper device portion including a second body of semiconductor material spaced from the first body and extending horizontally between second source and drain regions; and a second gate structure around the second body, the second gate structure including a second gate electrode and a second gate dielectric, the second gate dielectric between the second body and the second gate electrode; wherein the first gate dielectric is compositionally distinct from the second gate dielectric.

Example 2 includes the subject matter of Example 1, wherein the first gate electrode is compositionally distinct from the second gate electrode.

Example 3 includes the subject matter of Example 1 or Example 2, comprising a layer of isolation material between the first gate electrode and the second gate electrode.

Example 4 includes the subject matter of any of Examples 1-3, wherein the first gate dielectric includes a first native oxide on the first body and a first high-κ dielectric on the first native oxide, and wherein the second gate dielectric includes a second native oxide on the second body and a second high-κ dielectric on the second native oxide.

Example 5 includes the subject matter of any of Examples 1-4, wherein the first body is compositionally distinct from the second body.

Example 6 includes the subject matter of any of Examples 1-5, comprising a dipole species in one or both of the first gate dielectric and the second gate dielectric.

Example 7 includes the subject matter of Example 6, wherein the dipole species comprises one or more of aluminum, barium, cerium, chromium, cobalt, dysprosium, erbium, europium, gadolinium, holmium, lanthanum, lutetium, magnesium, manganese, molybdenum, neodymium, niobium, praseodymium, samarium, scandium, strontium, terbium, thulium, titanium, ytterbium, or yttrium. In a more specific example, the dipole species comprises aluminum, chromium, gallium, lanthanum, magnesium, molybdenum, niobium, scandium, strontium, or yttrium.

Example 8 includes the subject matter of Example 6, wherein the dipole species is in both the first gate dielectric and the second gate dielectric, and wherein a concentration of the dipole species in the first gate dielectric is different from a concentration of the dipole species in the second gate dielectric.

Example 9 includes the subject matter of any of Examples 6-8, wherein the dipole species has a relatively greater concentration at an interface between the first high-κ dielectric and the first native oxide and/or at an interface between the second high-κ dielectric and the second native oxide.

Example 10 includes the subject matter of any of Examples 6-7, wherein the dipole species is only in the first gate dielectric, the integrated circuit comprising a layer comprising titanium and nitrogen between the first gate dielectric and the first gate electrode.

Example 11 includes the subject matter of Example 10, comprising a diffusion barrier layer between the first gate electrode and the layer comprising niobium, tantalum, titanium, or vanadium.

Example 12 includes the subject matter of any of Examples 10-11, wherein the first gate electrode is compositionally distinct from the second gate electrode.

Example 13 includes the subject matter of any of Examples 10-12, comprising a layer of isolation material between the first gate electrode and the second gate electrode.

Example 14 includes the subject matter of any of Examples 1-13, wherein the first body is one of a first plurality of bodies and the second body is one of a second plurality of bodies.

Example 15 includes the subject matter of Example 14, wherein bodies of the first and second pluralities of bodies are selected from nanowires, nanoribbons, and nanosheets.

Example 16 includes the subject matter of any of Examples 1-15, wherein the first body and the second body comprise (i) a Group IV semiconductor material or (ii) a Group III-V semiconductor material.

Example 17 includes the subject matter of any of Examples 1-16, wherein one of the lower device portion or the upper device portion is configured as an n-MOS transistor device and the other of the lower device portion and the upper device portion is configured as a p-MOS transistor device.

Example 18 is an integrated circuit comprising at least one first body of semiconductor material extending horizontally between and connecting a first source and a first drain; at least one second body of semiconductor material extending horizontally between and connecting a second source and a second drain, the at least one second body arranged with the at least one first body in a spaced-apart vertical stack; a first gate structure wrapped around the at least one first body, the first gate structure comprising a first gate electrode and a first gate dielectric wherein the first gate dielectric is between the first gate electrode and the at least one first body; and a second gate structure wrapped around the at least one second body, the second gate structure comprising a second gate electrode and a second gate dielectric wherein the second gate dielectric is between the second gate electrode and the at least one second body; wherein the first gate dielectric is compositionally distinct from the second gate dielectric; and wherein the at least one first body and the at least one second body are selected from a nanowire, nanoribbon, or nanosheet.

Example 19 includes the subject matter of Example 18, wherein the first gate electrode is compositionally distinct from the second gate electrode.

Example 20 includes the subject matter of any of Examples 18-19, comprising a layer of isolation material between the first gate electrode and the second gate electrode.

Example 21 includes the subject matter of any of Examples 18-20, comprising a dipole species in one or both of the first gate dielectric and the second gate dielectric, a composition of the dipole species in the first gate dielectric different from a composition of the dipole species in the second gate dielectric.

Example 22 includes the subject matter of any of Examples 18-20, comprising a dipole species in the first gate dielectric.

Example 23 includes the subject matter of any of Examples 21-22, wherein the dipole species is selected from aluminum, barium, cerium, chromium, cobalt, dysprosium, erbium, europium, gadolinium, holmium, lanthanum, lutetium, magnesium, manganese, molybdenum, neodymium, niobium, praseodymium, samarium, scandium, strontium, terbium, thulium, titanium, ytterbium, or yttrium. In a more specific example, the dipole species comprises aluminum, chromium, gallium, lanthanum, magnesium, molybdenum, niobium, scandium, strontium, or yttrium.

Example 24 includes the subject matter of any of Examples 18-22, comprising a diffusion barrier layer between the first gate dielectric and the first gate electrode.

Example 25 includes the subject matter of any of Examples 1-24, comprising a stacked transistor structure including at least one of a n-channel transistor and at least one of a p-channel transistor.

Example 26 is an integrated circuit die comprising the integrated circuit of any of Examples 1-25.

Example 27 includes the subject matter of Example 26, comprising a processor.

Example 28 includes the subject matter of Example 26, wherein the integrated circuit die comprises a memory.

Example 29 includes the subject matter of any of Examples 26-28, wherein the integrated circuit die is part of a communication chip.

Example 30 includes the subject matter of any of Examples 26-28, wherein the integrated circuit is part of a touch screen controller.

Example 31 is a computing system comprising the integrated circuit of any of Examples 1-25 or the integrated circuit die of any of Examples 26-30.

Example 32 includes the subject matter of Example 31, comprising one or more of a communication chip, a touch screen controller, and a memory structure.

Example 33 is a method of fabricating a nanoribbon transistor structure, the method comprising providing a transistor structure including an upper device portion and a lower device portion, the transistor structure including bodies of semiconductor material extending between source and drain regions and arranged in a spaced-apart vertical stack; depositing a first high-κ dielectric on bodies in the lower device portion; depositing a second high-κ dielectric on bodies in the upper device portion, the second high-κ dielectric compositionally distinct from the first high-κ dielectric; depositing a dipole species over the one or both of the first high-κ dielectric and the second high-κ dielectric; annealing the transistor structure, thereby causing the dipole species to diffuse into the first high-κ dielectric and/or the second high-κ dielectric; and depositing a gate conductor around the bodies in the upper and lower device portions.

Example 34 includes the subject matter of Example 33, wherein the dipole species comprises one or more of aluminum, barium, cerium, chromium, cobalt, dysprosium, erbium, europium, gadolinium, holmium, lanthanum, lutetium, magnesium, manganese, molybdenum, neodymium, niobium, praseodymium, samarium, scandium, strontium, terbium, thulium, titanium, ytterbium, or yttrium. More specifically, the dipole species may be selected from aluminum, chromium, gallium, lanthanum, magnesium, molybdenum, niobium, scandium, strontium, or yttrium.

Example 35 includes the subject matter of any of Examples 33-34, comprising depositing a template material on at least some of the bodies of semiconductor material prior to depositing the dipole species.

Example 36 includes the subject matter of any of Examples 33-35, wherein depositing the gate conductor includes depositing a first gate conductor around bodies in the lower device portion and depositing a second gate conductor around bodies in the upper device portion, the first gate conductor compositionally distinct from the second gate conductor.

Example 37 includes the subject matter of Example 36, comprising depositing isolation material between the first and second gate conductors.

Example 38 includes the subject matter of any of Examples 33-37, comprising depositing a diffusion barrier layer on at least some of the bodies prior to depositing the gate conductor.

Example 39 includes the subject matter of any of Examples 33-38, comprising forming a native oxide on the bodies prior to depositing the first and second high-κ dielectrics.

The foregoing description of example embodiments has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future-filed applications claiming priority to this application may claim the disclosed subject matter in a different manner and generally may include any set of one or more limitations as variously disclosed or otherwise demonstrated herein.

## Claims

1. An integrated circuit comprising:
a lower device portion including first body of semiconductor material extending horizontally between first source and drain regions;
a first gate structure around the first body, the first gate structure including a first gate electrode and a first gate dielectric, the first gate dielectric between the first body and the first gate electrode;
an upper device portion above the lower device portion, the upper device portion including a second body of semiconductor material spaced from the first body and extending horizontally between second source and drain regions; and
a second gate structure around the second body, the second gate structure including a second gate electrode and a second gate dielectric, the second gate dielectric between the second body and the second gate electrode;
wherein the first gate dielectric is compositionally distinct from the second gate dielectric.

2. The integrated circuit of claim 1, wherein the first gate electrode is compositionally distinct from the second gate electrode.

3. The integrated circuit of claim 1 or 2, comprising a layer of isolation material between the first gate electrode and the second gate electrode.

4. The integrated circuit of any one of claims 1 through 3, wherein the first gate dielectric includes a first native oxide on the first body and a first high-κ dielectric on the first native oxide, and wherein the second gate dielectric includes a second native oxide on the second body and a second high-κ dielectric on the second native oxide.

5. The integrated circuit of any one of claims 1 through 4, wherein the first body is compositionally distinct from the second body.

6. The integrated circuit of any one of claims 1 through 5, comprising a dipole species in one or both of the first gate dielectric and the second gate dielectric.

7. The integrated circuit of claim 6, wherein the dipole species comprises one or more of aluminum, barium, cerium, chromium, cobalt, dysprosium, erbium, europium, gadolinium, holmium, lanthanum, lutetium, magnesium, manganese, molybdenum, neodymium, niobium, praseodymium, samarium, scandium, strontium, terbium, thulium, titanium, ytterbium, or yttrium.

8. The integrated circuit of claim 6, wherein the dipole species comprises aluminum, chromium, gallium, lanthanum, magnesium, molybdenum, niobium, scandium, strontium, or yttrium.

9. The integrated circuit of claim 6, wherein the dipole species is in both the first gate dielectric and the second gate dielectric, and wherein a concentration of the dipole species in the first gate dielectric is different from a concentration of the dipole species in the second gate dielectric.

10. The integrated circuit of any one of claims 6 through 9, wherein the dipole species has a relatively greater concentration at an interface between the first high-κ dielectric and the first native oxide and/or at an interface between the second high-κ dielectric and the second native oxide.

11. The integrated circuit of any one of claims 6 through 8, wherein the dipole species is only in the first gate dielectric, the integrated circuit comprising a layer comprising titanium and nitrogen between the first gate dielectric and the first gate electrode.

12. The integrated circuit of claim 11, comprising a diffusion barrier layer between the first gate electrode and the layer comprising niobium, tantalum, titanium, or vanadium.

13. The integrated circuit of any one of claims 1 through 12, wherein one of the lower device portion or the upper device portion is configured as an n-MOS transistor device and the other of the lower device portion and the upper device portion is configured as a p-MOS transistor device.

14. A method of fabricating a nanoribbon transistor structure, the method comprising:
providing a transistor structure including an upper device portion and a lower device portion, the transistor structure including bodies of semiconductor material extending between source and drain regions and arranged in a spaced-apart vertical stack;
depositing a first high-κ dielectric on bodies in the lower device portion;
depositing a second high-κ dielectric on bodies in the upper device portion, the second high-κ dielectric compositionally distinct from the first high-κ dielectric;
depositing a dipole species over the one or both of the first high-κ dielectric and the second high-κ dielectric;
annealing the transistor structure, thereby causing the dipole species to diffuse into the first high-κ dielectric and/or the second high-κ dielectric; and
depositing a gate conductor around the bodies in the upper and lower device portions.

15. The method of claim 14, wherein depositing the gate conductor includes depositing a first gate conductor around bodies in the lower device portion and depositing a second gate conductor around bodies in the upper device portion, the first gate conductor compositionally distinct from the second gate conductor, the method comprising one or more of:
depositing a template material on at least some of the bodies of semiconductor material prior to depositing the dipole species;
depositing isolation material between the first and second gate conductors;
depositing a diffusion barrier layer on at least some of the bodies prior to depositing the gate conductor; or
forming a native oxide on the bodies prior to depositing the first and second high-κ dielectrics.
